# EUROPEAN PATENT APPLICATION

(11) **EP 4 361 875 A1**
(43) Date of publication of application: **01.05.2024**
(21) Application number: 23205129.2
(22) Date of filing: 23.10.2023
(51) Int. Cl.: G06F 30/00, G06F 30/12, G06T 17/10, G06T 19/00, G06T 19/20

(54) **PROPAGATION OF CORNER TRIMMING OPTIONS ACROSS A 3D MODEL**

(30) Priority: 25.10.2022 US 202218049375
(71) Applicant: Dassault Systemes Solidworks Corporation, Waltham, MA 02451 (US)
(72) Inventor: Darwatkar, Sachin, Pune (IN); Kanjarkar, Satish, Pune (IN); Nimbalkar, Ranajit, Pune (IN)
(74) Representative: Bandpay & Greuter

(57) **Abstract**

A method automatically propagates a corner trimming in a 3D modeled object having a plurality of corners with a plurality of structural corner-members. Each corner includes a corner location and a count of its corner-members. The features of each corner-member include a cross-sectional shape and size, a corner-member location, and its relative orientation with respect to the other corner-members. A list of the corners and a selection of a seed corner is received. A target corner in the model is identified as topologically similar to the seed corner. A user definition of a trimming of the seed corner is automatically applied to the target corner.

## Description

### FIELD OF THE INVENTION

The present invention relates to design tools in a computer-aided design (CAD) environment, and more particularly, is related to steel and wooden structure design.

### BACKGROUND OF THE INVENTION

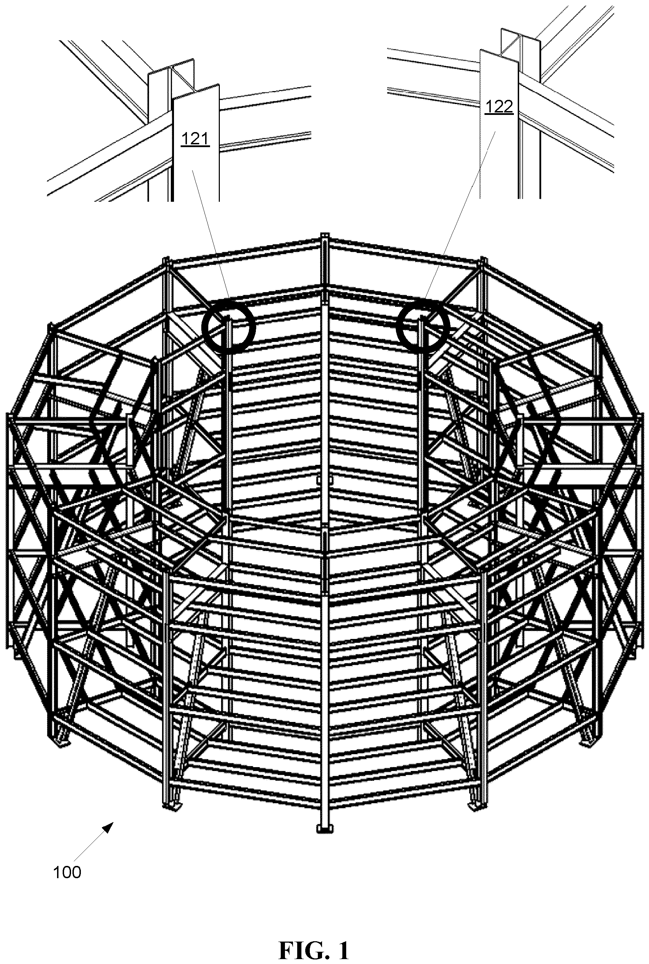

Design of steel and wooden structures involves creation of structural members, including vertical, horizontal, and inclined supports. A location where two or more such members meet is termed as a corner or a joint. As shown by FIG. 1, a structure 100 may include multiple corners 121, 122.

In the context of a CAD environment, a user of the CAD system defines a "trimming" for each corner of a modeled structure. Here, the user selects and appropriately trims (defines the geometry of) the end of one or more of the corner-members at the corner to create the desired corner-member placement and orientation. The user trims the corner-members various ways, for example, manipulating the member orientation and/or a combination of trim planes. A corner trimming generally involves the user specifying a trim order that defines a sequential order in which the corner-members are trimmed at a corner.

Achieving desired trim geometry by specifying trim options and order for each individual corner in a structure involving large number of corners is often a tedious task which consumes significant time and effort.

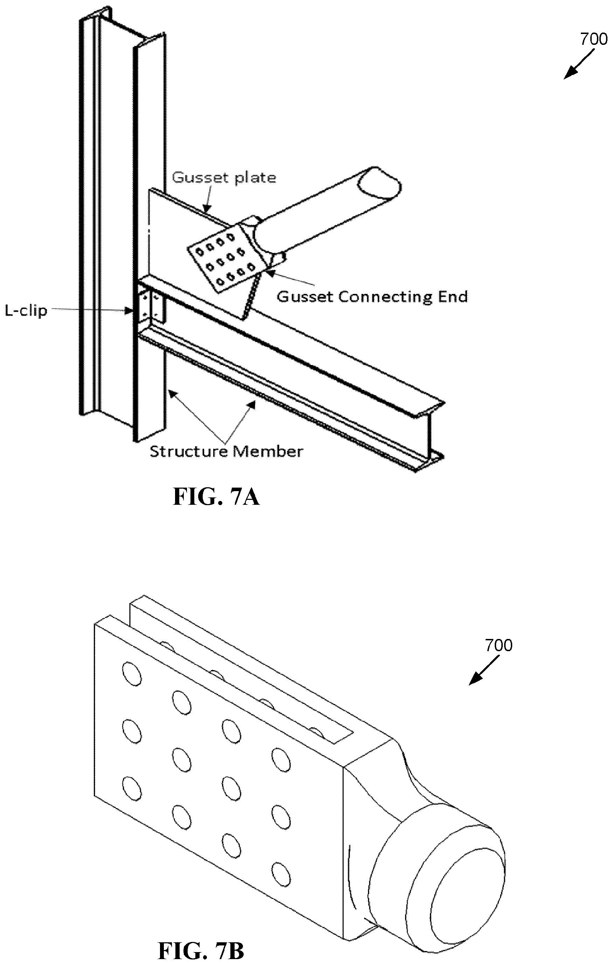

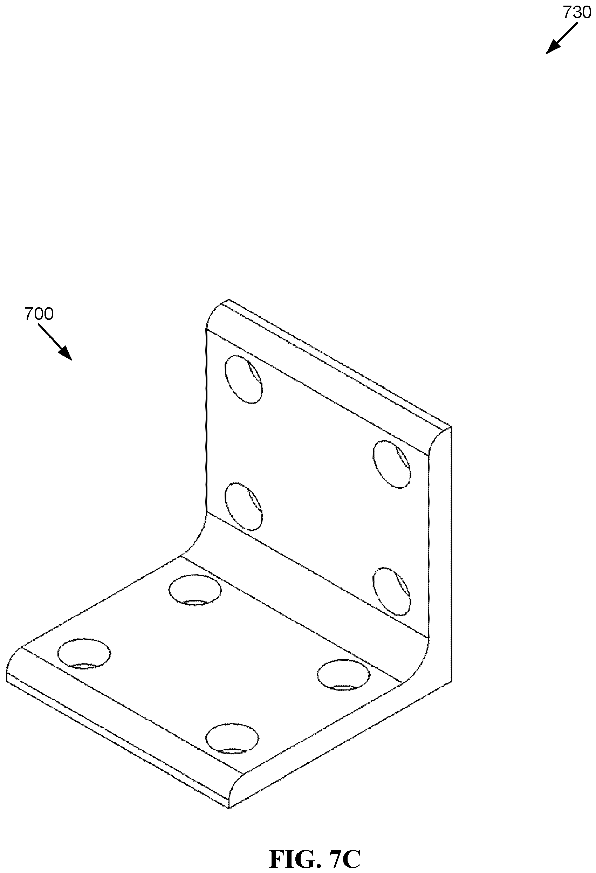

Structures may transfer their loading through a series of members to the ground. This is accomplished by designing connection elements 700 to join members at corners, as shown by FIGS. 7A-7C. Examples of connection elements include, but are not limited to bolted connections, L-clips, gusset plates, and fine plates, among others. Placing connection elements for each individual corner in a structure involving large number of corners may be a tedious task which takes significant time and effort. Therefore, there is a need in the industry to address the above-mentioned issues.

### SUMMARY OF THE INVENTION

Embodiments of the present invention provide a method for propagation of corner trimming options across a 3D model. Briefly described, the method automatically propagates a corner trimming in a 3D modeled object having a plurality of corners with a plurality of structural corner-members. Each corner includes a corner location and a count of its corner-members. The features of each corner-member include a cross-sectional shape and size, a corner-member location, and its relative orientation with respect to the other corner-members. A list of the corners and a selection of a seed corner is received. A target corner in the model is identified as topologically similar to the seed corner. A user definition of a trimming of the seed corner is automatically applied to the target corner.

Other systems, methods and features of the present invention will be or become apparent to one having ordinary skill in the art upon examining the following drawings and detailed description. It is intended that all such additional systems, methods, and features be included in this description, be within the scope of the present invention and protected by the accompanying claims.

The method is a computer-implemented method for designing a 3D modeled object by interaction of a user with a feature-based CAD system. The 3D modeled object represents a mechanical structure. The mechanical structure includes structural members. The mechanical structure further includes a plurality of corners. Each corner further comprises a plurality of structural corner-members of the model being connected together at the corner. The method automatically identifying topologically similar corners comprises the steps of receiving a parametric feature list of the plurality of corners, receiving a selection of a first corner of the plurality of corners and identifying a second corner in the model topologically similar to the first corner. Each model corner further comprises a corner location and a member count of the plurality of corner-members being connected together at the corner. The parametric features of each corner-member further comprise a cross-sectional shape and size, a corner-member location corresponding to one of the group consisting of: a member termination location and a member intermediate location, and a relative orientation with respect to each of the other corner-members.

The method may comprise one or more of the following:
- The method further comprises the step of automatically classifying the first corner and/or the second corner;
- Identifying the second corner in the model topologically similar to the first corner further comprises the steps of:
   ∘ comparing the first corner with the second corner, further comprises the steps of:
      ∘ determining the first corner and the second corner have the same member count; and
      ∘ identifying a plurality of corner-member pairings corresponding to the member count,
      wherein each corner-member pairing comprises a second corner corner-member corresponding to a first corner corner-member;
- The method further comprises, for each corner-member pairing, the steps of:
   ∘ determining the first and second corner-member have a matching cross sectional size and shape;
   ∘ determining the second corner-member location relation to the second corner location is the same as the first corner-member location relation to the first corner; and
   ∘ determining the first and second corner-members are either parallel or anti-parallel;
- The method further comprises, for each corner-member pairing, the steps of:
   ∘ determining the first and second corner-member have a matching cross sectional size and shape;
   ∘ determining the second corner-member location relation to the second corner location is the same as the first corner-member location relation to the first corner;
   ∘ determining the first and second corner-members are neither parallel nor anti-parallel;
   ∘ determining either:
      ▪ the first corner and the second corner are identical except for a relative orientation of the corner-members; or
      ▪ the first corner and the second corner are mirror images; and
      ▪ computing a transformation between the first corner and the second corner;
- The transformation between the first corner and the second corner comprises a rigid body transformation;
- The transformation between the first corner and the second corner comprises a mirror transformation;
- The method further comprises the steps of:
   ∘ computing the mirror transform around a mirror plane constructed at the midpoint of a line joining the corner location points of the first corner and the second corners, wherein the direction of the line is normal to the mirror plane;
   ∘ applying the mirror transform to the second corner corner-member of each corner-member pair; and
   ∘ comparing the mirror-transformed second corner corner-member against a corresponding paired first corner corner-member of the pair,
   wherein the first corner and the second corner are classified as topologically similar corners if every member from the first corner can be made coincident with a member from the second corner by applying the mirror transform;
- The method further comprises the step of indicating the second corner via a user interface of the CAD system;
- The method further comprises the steps of:
   ∘ receiving a user definition of a first trimming of the first corner;
   ∘ automatically applying the first trimming definition to the second corner;
- The user definition of the first trimming comprises a terminating geometry for a structural member of the first corner at the first corner intersection;
- The method further comprises the step of receiving a user selection of the second corner and automatically applying the first trimming definition to the second corner;
- The method further comprises the step of assigning the first corner and the second corner to a topologically similar corner group;
- The method further comprises the steps of:
   ∘ identifying a first corner corner-member designated as a trim tool;
   ∘ designating, a corresponding corner-member of the second corner as a trim tool face; and
   ∘ locating a corresponding trim tool face on the corresponding corner-member
- The method further comprises the steps of:
   ∘ identifying a first corner corner-member designated as a trim tool;
   ∘ designating, a corresponding corner-member of the second corner as a trim tool face; and
   ∘ locating a corresponding trim tool face on the corresponding corner-member; and/or
- The method further comprises the steps of:
   ∘ identifying a first corner corner-member designated as a trim tool;
   ∘ designating, a corresponding corner-member of the second corner as a trim tool face;
   ∘ applying the transformation between the first corner and the second corner to the corresponding corner-member; and
   ∘ locating a corresponding trim tool face on the corresponding corner-member.

### BRIEF DESCRIPTION OF THE DRAWINGS

The accompanying drawings are included to provide a further understanding of the invention, and are incorporated in and constitute a part of this specification. The components in the drawings are not necessarily to scale, emphasis instead being placed upon clearly illustrating the principles of the present invention. The drawings illustrate embodiments of the invention and, together with the description, serve to explain the principles of the invention.
FIG. 1 is a schematic diagram showing an exemplary modeled structure with a plurality of corners.
FIG. 2A is a schematic diagram of a complex corner for a 3D modeled structure.
FIG. 2B is an exploded view schematic diagram of the complex corner of FIG. 2A.
FIG. 3 is a flowchart of a first embodiment of a method for automatically identifying topologically similar corners of a 3D model.
FIG. 4 is a flowchart detailing the identification step of FIG. 3.
FIG. 5 is a flowchart detailing the application step of FIG. 3.
FIG. 6 is a schematic diagram of a modelled structure with corners having parallel and anti-parallel members.
FIG. 7A is a schematic diagram of an exemplary first corner connection element.
FIG. 7B is a schematic diagram of an exemplary second corner connection element.
FIG. 7C is a schematic diagram of an exemplary third corner connection element.
FIG. 8 is a schematic diagram illustrating an example of a system for executing functionality of the present invention.
FIG. 9 is a flowchart of an exemplary second embodiment of a method for copying a connection element from a first corner of a modeled structure to a topologically similar second corner of the modeled structure in the context of a CAD system.
FIG. 10 is a schematic diagram of an exemplary modeled structure referenced by FIG. 9.
FIG. 11 is a schematic diagram illustrating a first example of a trim tool.
FIG. 12 is a schematic diagram illustrating a second example of a trim tool.
FIG. 13 is a schematic diagram illustrating two connecting elements sharing a common connection face.

### DETAILED DESCRIPTION

The following definitions are useful for interpreting terms applied to features of the embodiments disclosed herein, and are meant only to define elements within the disclosure.

As used within this disclosure, an "automatic classification" refers to a computer execution of a sequence of steps in place of the user manually (via the CAD environment user interface) performing the individual steps. While in general all actions undertaken in a CAD environment are computer implemented, here automation refers to a grouping of related steps into tasks to reduce the user-computer interaction to perform the desired task. The level of user-computer interaction involved may depend on a level of automatism foreseen and put in balance with specified user preferences.

As used within this disclosure, a "modeled object" or "modeled structure" refers to a computer rendered representation of a physical structure, for example, a real-world product from the field of mechanical and/or electrical engineering. In general, the modeled object is represented by numerical data stored in data structures manipulated via a CAD system, which may be referred to as the CAD environment, where the modeled object may be represented by the CAD environment user interface, for example, graphically in two or three dimensions, and/ or via parts/components lists, among others.

As used within this disclosure, the expression "mechanical structure" designates an object or assembly which presents a mechanical skeleton or mainframe. Here, a mechanical structure includes structural members (i.e., elongate solids, optionally rigid) which are connected together. Two structural members are said to be connected together if they join or contact each other.

As used within this disclosure, a "corner" refers to a location of a mechanical structure at which a plurality of structural members ("corner-members") are connected. The connections may be of any type, for example mechanical (e.g., achieved via a fastener, or alternatively a mere contact), chemical (e.g., achieved by sticking), and/or thermic (e.g., achieved using thermic energy, for example via welding). In general, connections may arrest/lock all degrees of freedom and make it rigid to hold members together and provide strength to the structure without allowing any movement.. In examples of the case of a welding connection, the weld may forbid any movement of the connected structural members one relative to another. The structural members of the mechanical structure of the method may include straight structural members and/or curved structural members. The mechanical structure may be defined with respect to a main axis aligned with the vertical axis. In such a case, the structural members may comprise horizontal structural members, which may also be referred to as "beams," and/or vertical structural members, which may also be referred to as "columns."

The mechanical structure may be any type of mechanical structure, for example a metal structure. Examples of metal structures which may be represented by the 3D modeled object designed by the method include (but are not limited to):
a machine frame, the structural members being for example bars forming the mechanical frame of a machine, the machine being any type of machine such as a measurement and/or production machine,
a structural system based on one or more aluminum extrusion profiles, the structural members being for example aluminum extrusions optionally presenting all a same profile or alternatively at least two different profiles,
a steel structure, the structural members being for example steel beams, steel reinforcement bars and/or steel columns, optionally supporting a building or any type of construction, the corners being for example achieved with bolted joints.
a welded structure, the corners being for example achieved with weld joints between structural members which may be bars (note that a steel structure and a welded structure may be designed in a same way), or
a vehicle structure, the structural members forming for example the supporting frame of a vehicle, e.g., which may be any type of vehicle, for example a terrestrial vehicle such as a car or a truck, a water vehicle such as a boat or a ship, an air vehicle such as an airplane or a helicopter.

As used within this disclosure, a "corner type" refers to a classification of a corner based on the number of structural members ("member count") included in the corner and if/how the structural members terminate (have an "extremity") at the corner. For example, a "simple corner" is a corner where exactly two structural members are connected, one of which not at an extremity thereof (e.g., an extremity of one of the two structural members arrives at a location of the other structural member which is not an extremity of said other structural member). A "two-member corner" is a corner where exactly two structural members are connected, both at an extremity thereof (i.e., an extremity of one of the two structural members arrives at an extremity of the other structural member). A complex corner is a corner where strictly more than two structural members are connected (e.g., extremities of two or more structural members arrive at a third structural member, for example at an extremity thereof or alternatively at a non-extremity location thereof).

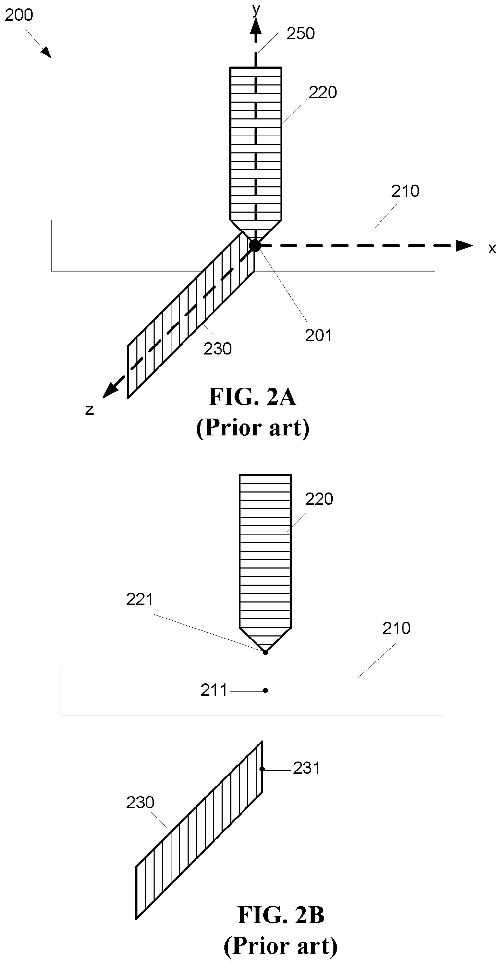

As used within this location a "corner location" refers to the location of a single point of the corner with respect to an origin location of the model. Each corner of a model has a unique corner location. FIG. 2A shows a complex corner 200 having a first structural member 210 along to an x-axis of a coordinate system 250, a second structural member 220 along a y-axis, and a third structural member 230 along a z-axis. The corner structural members 210, 220, 230 meet at a corner location 201. The corner orientation is defined by the direction of every member of the corner. FIG. 2B shows an exploded version of the corner 200 where the first structural member 210 has a first corner intersect location 211, the second structural member 220 has a second corner intersect location 221, and the third structural member 230 has a third corner intersect location 231, where each of the first, second, and third corner intersect locations 211, 221, 231 correspond with the corner location 201 (FIG. 2A). Here, the second intersect location 221 corresponds with an extremity of the second structural member 221, and the third corner intersect location 231 corresponds with an extremity of the third structural member 230, while the first intersect location 211 corresponds to an intermediate portion of the first structural member 210.

As used within this disclosure, "identical corners" share the same number of members (have an equal "member count"), and the same member geometry, but distinct corner locations.

As used within this disclosure, a first corner and a second corner in a modeled object are referred to as "topologically similar" if they are
(1) identical corners,
(2) identical except for a rotational transformation, or
(3) mirror images.

As used within this disclosure, a "trim" or "trimming" of a corner refers to a definition of the end geometry of each structural member terminating at the corner. A trimming of a first corner may be applied to a second corner if the first and second corners are topologically similar.

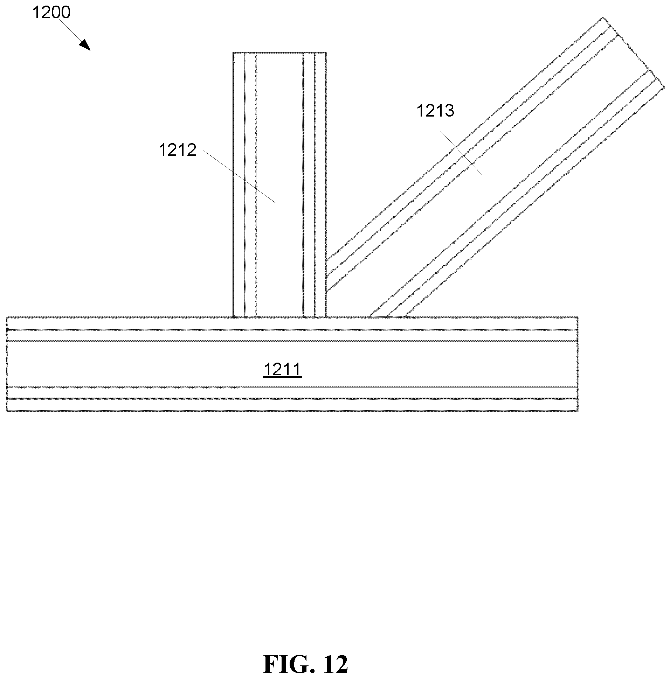

As used within this disclosure, a "trim tool " is a member which would cut away the intersecting/interfering material from other member(s) when two or more members meet at a corner. FIG. 12 shows a corner 1200 where a horizontal member 1211 trims (subtracts material) from other corner members 1212, 1213 of the corner 1200. As used within this disclosure, a "reference" refers to a data structure describing a geometric feature of a CAD model. A corner reference includes data for a corner of the structure, for example, coordinates of the corner point, the direction, and the root point of plane from connection elements and structure members used to define placement and orientation of the corner.

As used within this disclosure, a "parametric corner" refers to a listing of structural members of a corner and the features (e.g., geometric parameters) of the structural members at the corner. The CAD system maintains a listing of each parametric corner in the model. The user may select the parametric corner features to apply a corner trimming.

As used within this disclosure, an "indication" of a portion of a model refers to a graphical enhancement of the indicated portion, for example, an enhanced outline (e.g., thickened, or colored), a pointer element, or a high contrast color representation.

As used within this disclosure, a "connection element" refers to a material and/or means to join members at a corner. Examples of connection elements include, but are not limited to bolted connections, L-clips, gusset plates, and fine plates, among others.

Reference will now be made in detail to embodiments of the present invention, examples of which are illustrated in the accompanying drawings. Wherever possible, the same reference numbers are used in the drawings and the description to refer to the same or like parts.

Exemplary embodiments of the present invention are directed to a method for identifying topologically similar corners in a computer modeled structure and sorting them into groups. Corners may be classified as topologically similar or different by applying multiple levels of checks. A first level check includes comparison of several parameters of the corners, for example, but not limited to, a number of corner-members ("member count") and the cross sectional geometry of the corner-members. A second level check may involve comparing the relative orientation of respective corner-members as described below. If two corner-members meet the criteria for these checks, they are classified as identical corners. The identical corners of computer modeled structure may then be grouped for subsequent operations, for example, displaying a group of identical corners and applying a user trimming of a seed corner to a group of topologically similar corners, among others.

User identification of topologically similar corners in a modeled system can be time consuming and error-prone. Automatically identifying and/or grouping corners that have been classified as being topologically similar corners provides a technical solution to this technical problem, allowing for the groups to be manipulated and/or modified together, reducing time in designing/implementing corners, and reducing errors and omissions in the modeled object. For example, corners that may appear visually similar to a CAD system user from a displayed perspective may be mis-identified by a user as being similar. Likewise, a displayed perspective may make similar corners appear dissimilar. Further, mere visual identification may result in missing similar corners that have rotated orientations, or anti-parallel (mirrored) elements. Therefore, more than just being a time saving convenience, the embodiments represent an actual improvement in previous methods for identifying similar corners and propagating corner trimmings and/or corner connection elements accordingly.

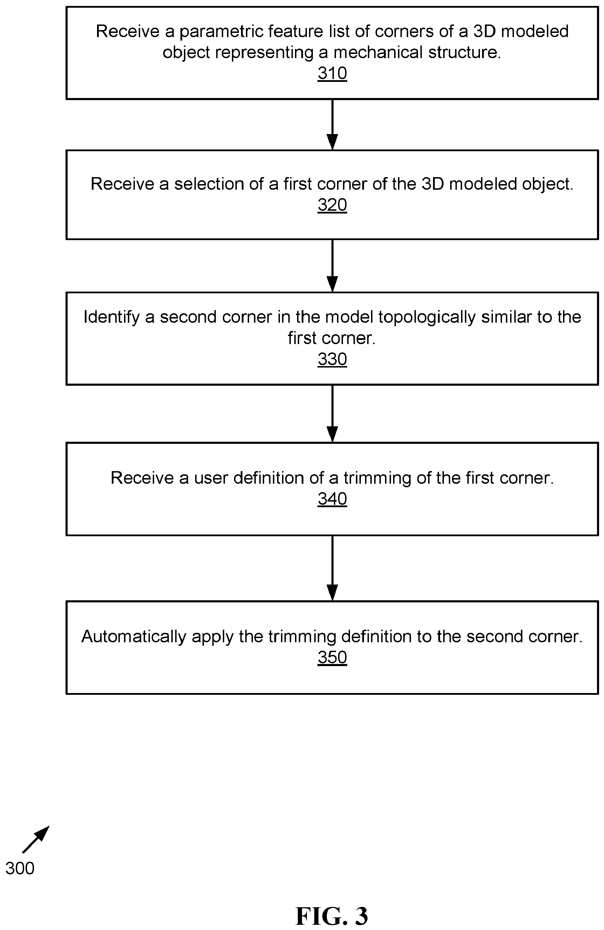

FIG. 3 is a flowchart of a first embodiment of a computer-implemented method for designing a 3D modeled object by interaction of a user with a feature-based CAD system. The 3D modeled object representing a mechanical structure. The mechanical structure includes structural members and a plurality of corners, each corner further having a plurality of structural members connected together at the corner. The method automatically identifies topologically similar corners of the model.

It should be noted that any process descriptions or blocks in flowcharts should be understood as representing modules, segments, portions of code, or steps that include one or more instructions for implementing specific logical functions in the process, and alternative implementations are included within the scope of the present invention in which functions may be executed out of order from that shown or discussed, including substantially concurrently or in reverse order, depending on the functionality involved, as would be understood by those reasonably skilled in the art of the present invention.

A parametric feature list of the plurality of corners of the 3D modeled object representing a mechanical structure is received, as shown by block 310. Each corner includes a corner location, and a member count of the structural members connected together at the corner ("corner-members"). Parametric features of each corner-member include a cross-sectional shape and size; a corner-member location consisting of either a member termination location 221, 231 (FIG. 2B) (for a corner-member terminating at the corner), or a member intermediate location 211 (FIG. 2A) (for a corner-member not terminating at the corner). Other corner-member features include a relative orientation with respect to each of the other corner-members.

A selection of a first corner of the plurality of corners is received, as shown by block 320. The selection of the first corner may be a user selection, for example via a graphical user interface (GUI) of the CAD system, or may be arbitrary, for example, in a scenario when all corners in the model are being classified and/or grouped. A second corner in the model topologically similar to the first corner is identified, as shown by block 330. A user definition of a trimming of the first corner is received, as shown by block 340. The trimming definition is automatically applied to the second corner, as shown by block 350.

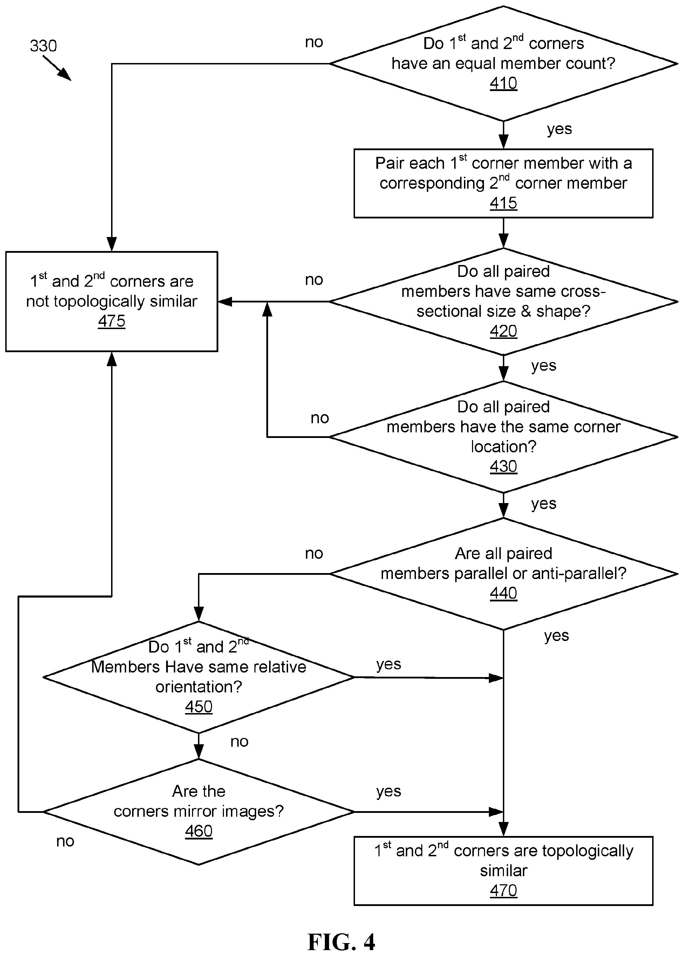

FIG. 4 shows the identification of block 330 in greater detail. Identifying a second corner in the model topologically similar to the first corner involves comparing the first corner with the second corner. A member count for the first corner and the second corner is compared, as shown by block 410. Corner-member pairings are identified, each pairing having a second corner corner-member corresponding to a first corner corner-member, as shown by block 420. The cross-sectional size and shape of the paired corner-members is compared, as shown by block 425. The corner location of the paired corner-members is compared, as shown by block 430. The matched corner-member pairs are checked for being either parallel or anti-parallel. If all of the checks in blocks 410, 420, 430, 440 are affirmative, the first and second corners are topologically similar (substantially identical), as shown by block 470.

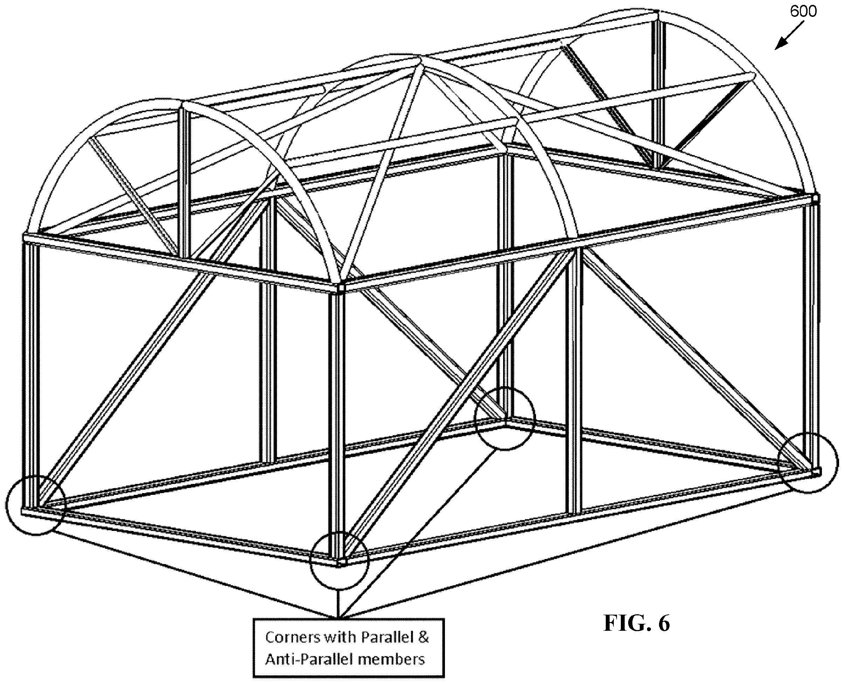

If blocks 410, 420, 430 are affirmative, but the paired members are neither parallel nor anti-parallel, block 450 checks if all first and second paired members have the same orientation relative to their respective corners. FIG. 6 shows a structure with parallel and anti-parallel corner-members.

If all first and second paired corner-members have the same relative orientation, the first and second corners are topologically similar, as shown by block 470. If all first and second paired members do not have the same relative orientation, the first and second corners are checked for being mirror images, as shown by block 460. If the first and second corners are mirror images, the first and second corners are topologically similar, as shown by block 470.

If the first and second corners are deemed topologically similar, the user interface of the CAD system may visually indicate the second corner, for example, by highlighting, outlining, encircling the second corner in a graphical representation of the model.

Once the corner comparison has passed the initial criteria (corresponding member count (block 410), corner-member shapes/sizes (block 420), member-corner locations (block 430)), but at least one of the corresponding member pairs is neither parallel nor anti-parallel (block 440), the method checks the relative orientation of members of the two corners (blocks 450, 460). At a high level, the method iterates through paired members of the first and second corners, computing a rigid body transformation matrix which, when applied to the location of the corresponding member, makes them coincident. The method applies the transform to every corner-member location/direction of the pair second member to determine whether the first/second corner-members coincide in terms of location and direction relative to the respective corner.

To determine if two given corners are topologically similar, the following mathematical operations are performed. An angle bisector is computed for all member directions of each corner by adding normalized vectors for each one of the member directions. The angle bisector is a line at an equal angle to each of the member direction vectors. Member direction vectors are computed by subtracting a first 3D (x,y,z) corner point from a second 3D end point on an opposite end of the member and normalizing the result vector. For example, for FIG. 1, the angle bisector vector for a left corner 121 is { -0.31, -0.9, 0.31 } and is { -0.42, -0.9, -0.1 } for the right corner 122.

A 3D transformation matrix is computed. Multiplying the 3D transformation matrix with the angle bisector vector of the right corner makes the right corner coincident with the angle bisector vector of the left corner. The matrix includes both translation and rotation components. For example, a computed 3D transformation matrix for the corners 121, 122 of FIG. 1 is shown in Table 1.

**Table 1: Angle Bisector Transformation Matrix for FIG. 1 corners 121, 122**

| **X-axis** | **Y-axis** | **Z-axis** | **Translation** |
|---|---|---|---|
| 0.98 | -0.13 | 0.14 | 3.18 |
| 0.07 | 0.92 | 0.39 | 2.23 |
| -0.2 | -0.37 | 0.91 | 10.54 |
| 0 | 0 | 0 | 1 |

The Member directions of each corner are traversed, processing the member direction from the left corner and the member direction from the right corner as explained below.
- A reference plane is created using a corner point (where all corner-members meet) as the root point and angle bisector vector of left corner as the normal.
- The angle bisector transform (Table 1) is multiplied with the right corner-member vector direction.
- A corner-member vector direction computed from the left corner and a transformed member vector direction computed from the left corner are projected on to the reference plane. An angle between these projected vector directions is computed.
- A rotation transformation is computed using the angle between the two projected vectors.

The rotational transformation is used to align the projected vector directions.
The computed 3D transformation matrix is shown in Table 2:

**Table 2: Rotation Transformation Matrix**

| **X-axis** | **Y-axis** | **Z-axis** | **Translation** |
|---|---|---|---|
| 0.61 | 0.37 | 0.69 | -10.54 |
| -0.13 | 0.91 | -0.37 | 2.23 |
| -0.78 | 0.13 | 0.61 | -3.82 |
| 0 | 0 | 0 | 1 |

The angle bisector transform (Table 1), and the rotation transform (Table 2) are multiplied to compute the final transform to align the two corners 121, 122. Table 3 shows the final transform.

**Table 3: Final transform**

| **X-axis** | **Y-axis** | **Z-axis** | **Translation** |
|---|---|---|---|
| 0.5 | 0.0 | -0.87 | 0.0 |
| 0.0 | 1.0 | 0.0 | 0.0 |
| 0.87 | 0.0 | 0.5 | 0.0 |
| 0 | 0 | 0 | 1 |

While the above description has generally described comparing a first corner with a second corner, the embodiments are applicable for comparing a first corner with multiple corners in the model. Given a corner count 'n' corresponding to the number of corners in a model, the following logic is used to identify the topologically similar corners and the corresponding matching members in each corner of the n corners of the model.

The method traverses n corners, comparing each corner with every other corner, where each corner may contain two or more corner-members. The comparison between a first corner and a second corner includes:
▪ Starting with the first corner-member of the first corner, a unit direction vector for each corner-member is computed by subtracting the 3D (x,y,z) corner point from the other 3D end point of the member and normalizing the result vector.
▪ Similarly, the method computes unit direction vectors for each one of the corner-members from the second corner.
▪ The method computes a 3D transformation matrix, as described above. When applied, the transformation matrix coincides the direction vector of a member of the first corner with the direction vector of the corresponding member of the second corner.
▪ The 3D transformation matrix is multiplied with the direction vectors of all corner-members of the other corners and the resulting direction vectors are compared with the direction vectors of the corner-members from the first corner.
▪ The corners are identified as topologically similar if there is a matching corner-member found in the first corner for each corner-member of the other corner.

Returning to FIG. 4, block 460, the following procedure is used to establish whether a second corner is a mirror image of a first corner. First, a mirror transform is computed using a mirror plane constructed by the midpoint of a line joining the corner location points of the first and second corners. The direction of the line is normal to the mirror plane. Second, since it has been previously established the first and second corners have the same number of corner-members (see FIG. 4, block 410), the mirror transform is applied to the second corner corner-member of each corner-member pair, and checked against the corresponding first corner corner-member of the pair. The check determines if the location and direction of the first corner corner-members are the same as the transformed second corner corner-member. If every corner-member from the first corner can be made coincident with a corner-member from the second corner by applying the mirror transform, the corners are classified as topologically similar corners.

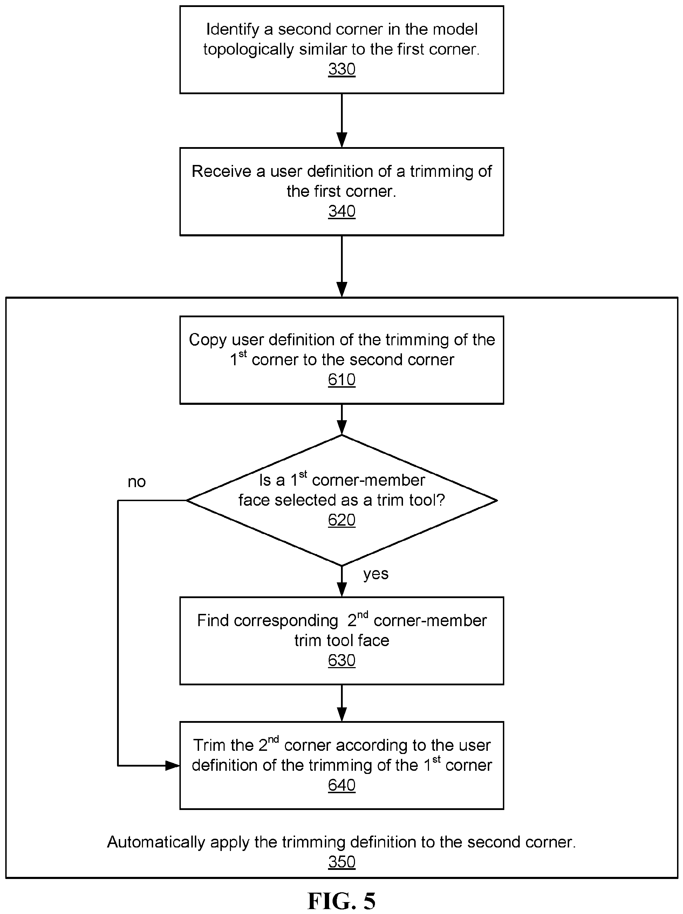

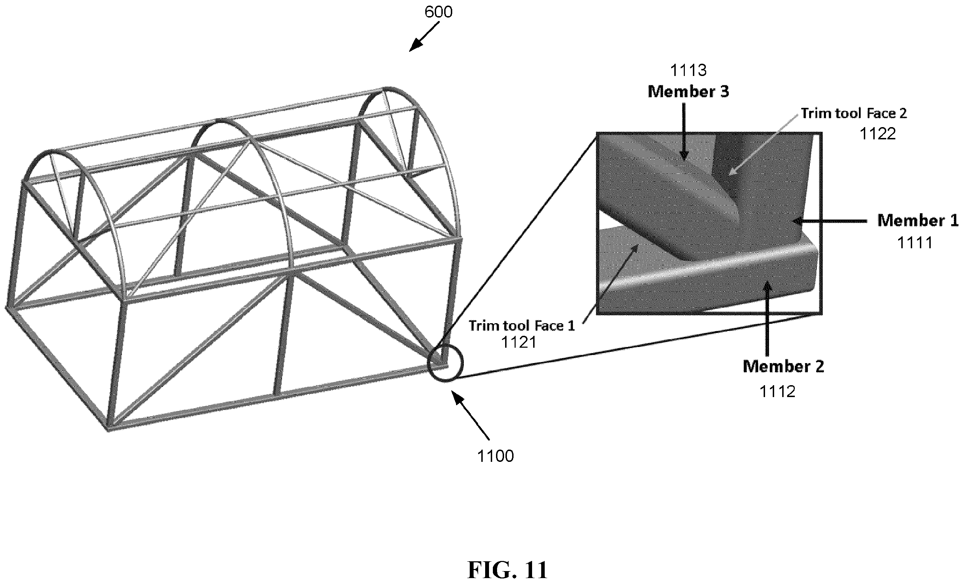

FIG. 5 shows the automatic application of a first corner trimming definition to the second corner (FIG. 3, block 350) in greater detail, described here with reference to FIG. 11. The user definition of the trimming of the first corner is copied to the second corner, as shown by block 610. Corner trim data may include, for example, but is not limited to, gap value, planar trim type, corner trim type, miter angle, and planar trim mode. The corner-member trim order and individual corner gap value is copied from the first corner to the second corner for matched corner-member pairs.

The first corner 1100 is checked for having one or more corner-members designated as a trim tool, as shown by block 620. If the first corner 1100 has one or more corner-members 1112, 1113 designated as a trim tool, a corresponding corner-member of the second corner is found and designated as a trim tool face 1121, 1122, as shown by block 630. The transformation matrix computed when determining the first and second corners are topologically similar is multiplied with the spatial coordinates of a point on the trim tool face 1121, 1122 of the first corner 1100, and the transformed point is used to locate the corresponding trim tool face on the second corner. The second corner is trimmed according to the user definition of the trimming of the first corner 1110, as shown by block 640.

Under a second exemplary embodiment, a user may select a seed connection element from a seed corner of the modeled structure, and the seed connection element is replicated and placed at one or more topologically similar corners. The replicated connection element is placed and oriented at the topologically similar corner as per the seed corner. The replicated connection element may be a rotation or a mirror image of the seed connection element.

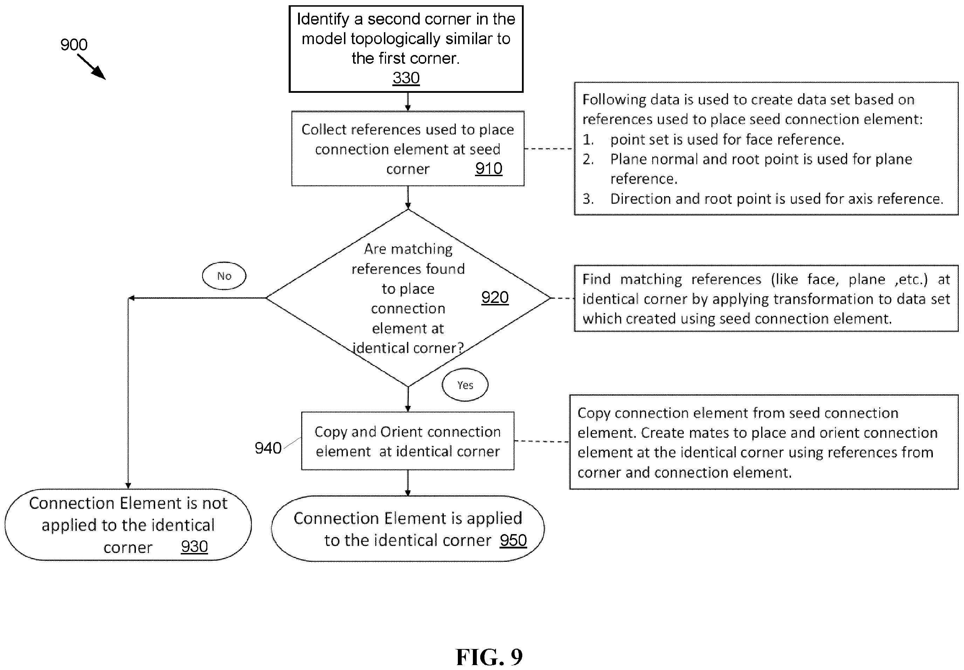

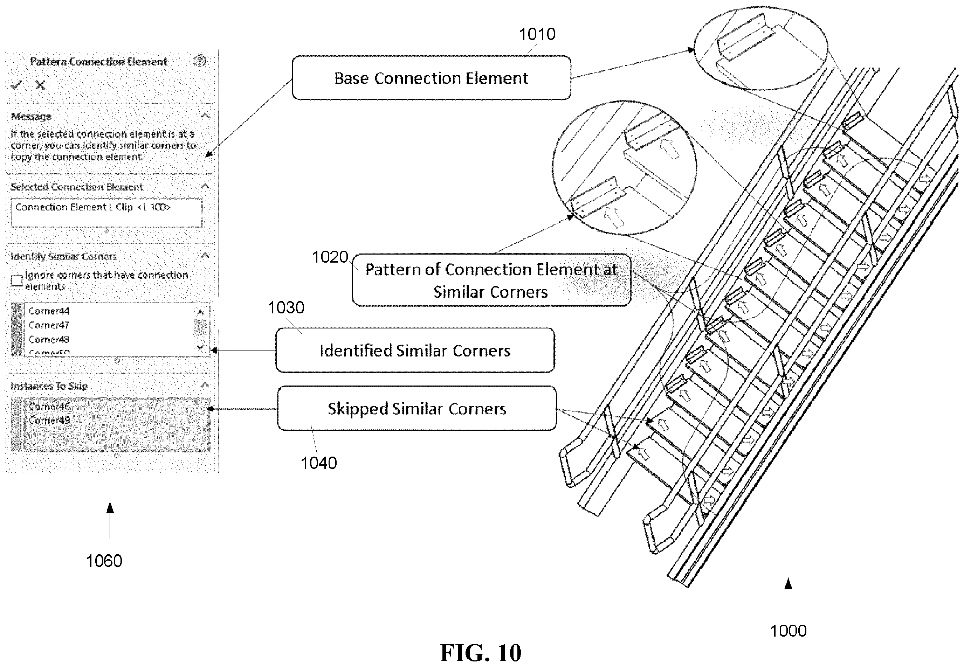

FIG. 9 is a flowchart 900 of an exemplary second embodiment of a method for copying a connection element from a first (seed) corner of a modeled structure to a topologically similar second (target) corner of the modeled structure in the context of a CAD system. FIG. 10 is a schematic diagram of an exemplary modeled structure 1000 referenced in the description of FIG. 9. A second corner in the model topologically similar to the first corner is identified, as shown by block 330, as depicted in FIG. 4, and described in detail above. The user interface 1060 of the CAD system may indicate one or more topologically similar corners 1030 of the modeled structure 1000, for example, as a text listing and/or as a graphical representation. References are collected to place a connection element 1010 at a seed corner (here, the first corner), as shown by block 910. The reference data collected depends upon the connection element type. For example, a point set is used for a face reference, plane normal and a root point is used for a plane reference, and a direction and a root point is used for an axis reference.

The method checks the second corner for a matching reference to place the connection element, as shown by block 920. For example, the matching references may be found using the transformation applied to the data set which was created using the seed connection element. Two outer faces of L-clip may coincide with structure member faces in a seed corner, so the method may then find coinciding structure member faces from a target corner to place L-clip in same orientation.

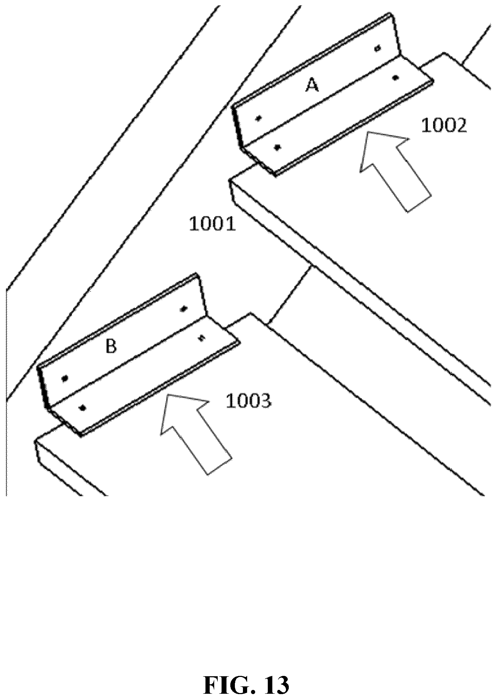

As shown by FIG. 13, a seed L-clip A uses faces 1001, 1002 face as a coinciding faces for placement. A target L-clip B patterned as per L-clip A uses faces 1001 and 1003 as coinciding faces for placement. Here clips A and B are share one common structure member, face 1001, so face 100 is common for clips A and B.

If no matching reference is found, the connection element is not applied to the second corner, as shown by block 930. A copy is made of the seed connection element, and the copied connection element is oriented for application at the second corner, as shown by block 940. The copied connection element is applied to the second corner, as shown by block 950.

If two corners are topologically identical, there may be scenarios where a connection element of the first corner may not be applied to the second corner. A connection element is fully defined by applying three constraint with respect to structure members. If any of constraint is not applied correctly then connection element would not fix or orient with respect to structure member. Certain conditions, for example, if a corresponding face or point or plane is not found due at target corner due to different trimming options or any other modeling operations, the matching reference may not be found, so that connection element will not be patterned at the target corner.

While the above describes using a seed connection element at a first corner to create a similar connection element at a second corner, the same process may be used to create similar connection elements at two or more corners, for example, all corners in a group of identified topologically similar corners 1030. In some implementations, the CAD system may provide a list of similar corners, and the user may select one or more (or all) of the corners for a similar connection element. The CAD system may provide a display 1020 of connection elements applied at topologically similar corners, and may further indicate skipped similar corners 1040 graphically or textually.

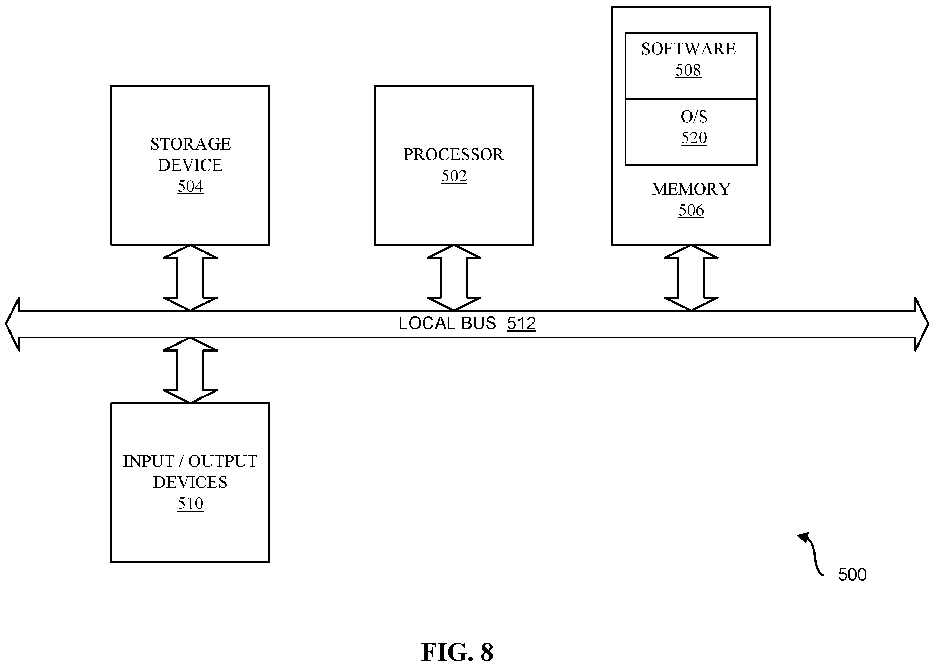

The present system for executing the functionality described in detail above may be a computer, an example of which is shown in the schematic diagram of FIG. 8. The system 500 contains a processor 502, a storage device 504, a memory 506 having software 508 stored therein that defines the abovementioned functionality, input, and output (I/O) devices 510 (or peripherals), and a local bus, or local interface 512 allowing for communication within the system 500. The local interface 512 can be, for example but not limited to, one or more buses or other wired or wireless connections, as is known in the art. The local interface 512 may have additional elements, which are omitted for simplicity, such as controllers, buffers (caches), drivers, repeaters, and receivers, to enable communications. Further, the local interface 512 may include address, control, and/or data connections to enable appropriate communications among the aforementioned components.

The processor 502 is a hardware device for executing software, particularly that stored in the memory 506. The processor 502 can be any custom made or commercially available single core or multi-core processor, a central processing unit (CPU), an auxiliary processor among several processors associated with the present system 500, a semiconductor based microprocessor (in the form of a microchip or chip set), a macroprocessor, or generally any device for executing software instructions.

The memory 506 can include any one or combination of volatile memory elements (*e.g*., random access memory (RAM, such as DRAM, SRAM, SDRAM, *etc.*)) and nonvolatile memory elements (*e.g.,* ROM, hard drive, tape, CDROM, *etc.*)*.* Moreover, the memory 506 may incorporate electronic, magnetic, optical, and/or other types of storage media. Note that the memory 506 can have a distributed architecture, where various components are situated remotely from one another, but can be accessed by the processor 502.

The software 508 defines functionality performed by the system 500, in accordance with the present invention. The software 508 in the memory 506 may include one or more separate programs, each of which contains an ordered listing of executable instructions for implementing logical functions of the system 500, as described below. The memory 506 may contain an operating system (O/S) 520. The operating system essentially controls the execution of programs within the system 500 and provides scheduling, input-output control, file and data management, memory management, and communication control and related services.

The I/O devices 510 may include input devices, for example but not limited to, a keyboard, mouse, scanner, microphone, *etc.* Furthermore, the I/O devices 510 may also include output devices, for example but not limited to, a printer, display, *etc.* Finally, the I/O devices 510 may further include devices that communicate via both inputs and outputs, for instance but not limited to, a modulator/demodulator (modem; for accessing another device, system, or network), a radio frequency (RF) or other transceiver, a telephonic interface, a bridge, a router, or other device.

When the system 500 is in operation, the processor 502 is configured to execute the software 508 stored within the memory 506, to communicate data to and from the memory 506, and to generally control operations of the system 500 pursuant to the software 508, as explained above.

When the functionality of the system 500 is in operation, the processor 502 is configured to execute the software 508 stored within the memory 506, to communicate data to and from the memory 506, and to generally control operations of the system 500 pursuant to the software 508. The operating system 520 is read by the processor 502, perhaps buffered within the processor 502, and then executed.

When the system 500 is implemented in software 508, it should be noted that instructions for implementing the system 500 can be stored on any computer-readable medium for use by or in connection with any computer-related device, system, or method. Such a computer-readable medium may, in some embodiments, correspond to either or both the memory 506 or the storage device 504. In the context of this document, a computer-readable medium is an electronic, magnetic, optical, or other physical device or means that can contain or store a computer program for use by or in connection with a computer-related device, system, or method. Instructions for implementing the system can be embodied in any computer-readable medium for use by or in connection with the processor or other such instruction execution system, apparatus, or device. Although the processor 502 has been mentioned by way of example, such instruction execution system, apparatus, or device may, in some embodiments, be any computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the processor or other such instruction execution system, apparatus, or device.

Such a computer-readable medium can be, for example but not limited to, an electronic, magnetic, optical, electromagnetic, infrared, or semiconductor system, apparatus, device, or propagation medium. More specific examples (a nonexhaustive list) of the computer-readable medium would include the following: an electrical connection (electronic) having one or more wires, a portable computer diskette (magnetic), a random access memory (RAM) (electronic), a read-only memory (ROM) (electronic), an erasable programmable read-only memory (EPROM, EEPROM, or Flash memory) (electronic), an optical fiber (optical), and a portable compact disc read-only memory (CDROM) (optical). Note that the computer-readable medium could even be paper or another suitable medium upon which the program is printed, as the program can be electronically captured, via for instance optical scanning of the paper or other medium, then compiled, interpreted, or otherwise processed in a suitable manner if necessary, and then stored in a computer memory.

In an alternative embodiment, where the system 500 is implemented in hardware, the system 500 can be implemented with any or a combination of the following technologies, which are each well known in the art: a discrete logic circuit(s) having logic gates for implementing logic functions upon data signals, an application specific integrated circuit (ASIC) having appropriate combinational logic gates, a programmable gate array(s) (PGA), a field programmable gate array (FPGA), etc.

The above described embodiments generally manipulate modeled objects and provide for structural design with improved ergonomics.

A modeled object is any object defined by data stored e.g., in the database. By extension, the expression "modeled object" designates the data itself. The modeled objects may be defined by different kinds of data according to the type of system. The system may be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD and PLM system.

By CAD system, it is additionally meant any system adapted at least for designing a modeled object on the basis of a graphical representation of the modeled object, such as CATIA^{™} or SOLIDWORKS^{™}. In this case, the data defining a modeled object includes data allowing the representation of the modeled object. A CAD system may for example provide a representation of CAD modeled objects using edges or lines, in certain cases with faces or surfaces. Lines, edges, or surfaces may be represented in various manners, e.g., non-uniform rational B-splines (NURBS). Specifically, a CAD file contains specifications, from which geometry may be generated, which in turn allows for a representation to be generated. Specifications of a modeled object may be stored in a single CAD file or multiple files. The typical size of a file representing a modeled object in a CAD system is in the range of one megabyte per part. A modeled object may typically be an assembly of thousands of parts.

In the context of CAD, a modeled object may typically be a 3D modeled object. By "3D modeled object", it is meant any object which is modeled by data allowing its 3D representation. A 3D representation allows the viewing of the mechanical structure from all angles. For example, a 3D modeled object, when so represented, may be handled and rotated around any of its axes, or around any axis in the screen on which the representation is displayed. This notably excludes 2D icons, which are not 3D modeled. The display of a 3D representation facilitates design (i.e., increases the speed at which designers statistically accomplish their task). This speeds up the manufacturing process in the industry, as the design of the products is part of the manufacturing process. Also, the 3D modeled object describes the 3D shape/geometry of the mechanical structure, in other words, the space distribution of material constitutive of the mechanical structure in the real world.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A computer-implemented method for designing a 3D modeled object by interaction of a user with a feature-based CAD system, the 3D modeled object representing a mechanical structure, the mechanical structure including structural members, the mechanical structure further including a plurality of corners, each corner further comprising a plurality of structural corner-members of the model being connected together at the corner, the method automatically identifying topologically similar corners comprising the steps of:
receiving a parametric feature list of the plurality of corners;
receiving a selection of a first corner of the plurality of corners; and
identifying a second corner in the model topologically similar to the first corner,
wherein each model corner further comprises:
a corner location; and
a member count of the plurality of corner-members being connected together at the corner, and the parametric features of each corner-member further comprise:
a cross-sectional shape and size;
a corner-member location corresponding to one of the group consisting of:
a member termination location; and
a member intermediate location; and
a relative orientation with respect to each of the other corner-members.

2. The method of claim 1, further comprising the step of automatically classifying the first corner and/or the second corner.

3. The method of claim 1, wherein identifying the second corner in the model topologically similar to the first corner further comprises the steps of:
comparing the first corner with the second corner, further comprises the steps of:
determining the first corner and the second corner have the same member count; and
identifying a plurality of corner-member pairings corresponding to the member count,
wherein each corner-member pairing comprises a second corner corner-member corresponding to a first corner corner-member.

4. The method of claim 3, further comprising, for each corner-member pairing, the steps of:
determining the first and second corner-member have a matching cross sectional size and shape;
determining the second corner-member location relation to the second corner location is the same as the first corner-member location relation to the first corner; and
determining the first and second corner-members are either parallel or anti-parallel.

5. The method of claim 3, further comprising, for each corner-member pairing, the steps of:
determining the first and second corner-member have a matching cross sectional size and shape;
determining the second corner-member location relation to the second corner location is the same as the first corner-member location relation to the first corner;
determining the first and second corner-members are neither parallel nor anti-parallel;
determining either:
the first corner and the second corner are identical except for a relative orientation of the corner-members; or
the first corner and the second corner are mirror images; and
computing a transformation between the first corner and the second corner.

6. The method of claim 5, wherein the transformation between the first corner and the second corner comprises a rigid body transformation.

7. The method of claim 5, wherein the transformation between the first corner and the second corner comprises a mirror transformation.

8. The method of claim 7, further comprising the steps of:
computing the mirror transform around a mirror plane constructed at the midpoint of a line joining the corner location points of the first corner and the second corners, wherein the direction of the line is normal to the mirror plane;
applying the mirror transform to the second corner corner-member of each corner-member pair; and
comparing the mirror-transformed second corner corner-member against a corresponding paired first corner corner-member of the pair,
wherein the first corner and the second corner are classified as topologically similar corners if every member from the first corner can be made coincident with a member from the second corner by applying the mirror transform.

9. The method of claim 1, further comprising the step of indicating the second corner via a user interface of the CAD system.

10. The method of claim 1, further comprising the steps of:
receiving a user definition of a first trimming of the first corner;
automatically applying the first trimming definition to the second corner,
wherein optionally the user definition of the first trimming comprises a terminating geometry for a structural member of the first corner at the first corner intersection.

11. The method of claim 10, further comprising the step of receiving a user selection of the second corner and automatically applying the first trimming definition to the second corner.

12. The method of claim 1, further comprising the step of assigning the first corner and the second corner to a topologically similar corner group.

13. The method of claim 1, further comprising the steps of:
identifying a first corner corner-member designated as a trim tool;
designating, a corresponding corner-member of the second corner as a trim tool face; and
locating a corresponding trim tool face on the corresponding corner-member.

14. The method of claim 5, further comprising the steps of:
identifying a first corner corner-member designated as a trim tool;
designating, a corresponding corner-member of the second corner as a trim tool face;
applying the transformation between the first corner and the second corner to the corresponding corner-member; and
locating a corresponding trim tool face on the corresponding corner-member.

15. A computer program comprising instructions which, when the program is executed by a computer, cause the computer to carry out the method of any one of claims 1 to 14.
